# EUROPEAN PATENT APPLICATION

(11) **EP 4 404 468 A1**
(43) Date of publication of application: **24.07.2024**
(21) Application number: 23152658.3
(22) Date of filing: 20.01.2023
(51) Int. Cl.: H03M 7/30

(54) **APPARATUS FOR COMPRESSING TIME SERIES DATA, METHOD FOR COMPRESSING TIME SERIES DATA AND COMPUTER PROGRAM PRODUCT**

(71) Applicant: Hitachi, Ltd., Tokyo 100-8280 (JP)
(72) Inventor: KATO, Tetsuji, London EC2Y (GB); KILSBY, Paul, London EC2Y (GB); INOUE, Takeshi, London EC2Y (GB)
(74) Representative: MERH-IP Matias Erny Reichl Hoffmann Patentanwälte PartG mbB

(57) **Abstract**

The present disclosure relates to an apparatus for compressing time series data comprising: a difference detection unit 30 configured to determine difference data from reference data and measurement data, a data compression unit 40 configured to compress the difference data determined by the difference detection unit 30, a data export 50 unit configured to provide the compressed difference data to a data storage device.

## Description

The present subject-matter relates to an apparatus for providing improved compression of time series data provided by a measurement data source. A corresponding method and computer program product are provided as well. The compression of time series data is especially improved by creating difference data/variance data by comparing reference data of a machine or device with actual measurement data of said machine or device in order to reduce the data volume of the measurement data. The difference data/variance data is then preferably subjected to lossless compression and sent to a data storage device and saved therein. Correspondingly, a more efficient way of compressing time series data output by a sensor monitoring a device or machine and hence a reduction in storage volume occupied by the compressed measurement data and/or reduced data traffic when transmitting the compressed measurement data can be provided. The computational costs of the compression may also be reduced in preferred aspects.

### Background

JP 2011/223244 A discloses a data compression device, which applies lossless compression processing to image data obtained by photographing a target to be measured in one or more wavelength bands, which comprises: an image data dividing means for dividing the pixel values of a single pixel into high-order bit data and low-order bit data at a predetermined bit number for division, the number being smaller than a predetermined bit number N representing a pixel value; a determination means for determining whether at least one of the divided bit data is suitable for compression; and a compression means for compressing at least one of the high-order bit data and low-order bit data of image data which is of the same kind of or similar to the aforementioned processed image data if at least one of the divided bit data is suitable for the compression.

In the above-described method, image data is compressed by obtaining a comparison value from surrounding pixels. However, this method cannot be used for the lossless compression of time series data because extracting data for compression would necessitate to obtain each original value of the raw data.

JP 2021/547155 A discloses a method supporting delta coding for remote sensing. For example, a system supporting remote sensing of information may include a processing capability configured for determining differences between the sensed information and a baseline condition, such as a base map of information. The determined differences from the baseline condition may be communicated over a communication link (e.g., a wireless communication link, a satellite communication link), which may be referred to as or be otherwise associated with a delta coding of information sensed by the remote sensor system. In some examples, delta coding may support a smaller transfer of information over a communication link than communicating an entirety of sensed information.

In this method, data is compressed by sending certain areas of video data. However, this method cannot be used for the lossless compression of time series data because it would not repeat the same data for a certain period.

### Problem and Solution

The above disclosures share the problem, that they are not applicable to time series data since physical measurement data cannot be compressed by lossy compression. In order to be able to restore all data points by decompressing the compressed data only lossless compression can be applied. Moreover, if lossless compression is performed to compress a data set, there still remains the problem that most of the commonly known lossless compression methods are not suitable to compress certain data types. In particular, datasets that exhibit a wide range of values are rather difficult to effectively compress in a lossless manner.

In view of the above, it is a technical object of the described subject-matter to provide an apparatus, a method and computer program product which are further improved in view of reducing the file size of time series data provided by a sensor and which preferably apply computational inexpensive operations.

This is solved by the subject-matter of the appended claims.

According to a first aspect, there is proposed an apparatus for the compression of time series data which may comprise the following features: a data storage device, preferably including a first data storage unit configured to store reference data; a difference detection unit configured to determine a difference (or difference data) between the reference data and measurement data and output the difference data. A measurement data source configured to provide the measurement data of a device to the apparatus, preferably to the different detection unit, may be a part of the apparatus or may be an external unit. The device is an external unit from which measurement data are taken/recorded/measured or the like. Further, the apparatus comprises a data compression unit configured to compress the difference data determined by the difference detection unit; and a data export unit configured to send/transmit the difference data to the data storage device preferably a second data storage unit of the data storage device configured to save the compressed difference data. If the optional data export unit is not provided in the apparatus, the data compression unit may take over these technical functions.

As noted above, the data storage device may can be for example, a solid-state drive or a hard disk drive suitable for permanently storing data. Of course, it can be any other kind of data storage device or unit. Furthermore, the first data storage unit may preferably be part of the data storage device, as for example, a partition or a virtual drive of said larger storage device or the like.

The term reference data shall be understood, preferably, as time series data that is used to generate difference data as a result of a mathematical operation, such as subtraction, from actual or saved measurement data. In the context of the claimed subject-matter, reference data can be, preferably, a set of data points along a time scale or an equation by which the time series data can be expressed. Said set of data points along a time axis can actually contain less data points than the data that has been used to create the reference data. Hence, the size of the reference data can be reduced and a system requiring reduced storage space can be provided. It is noted that one set of reference data can be used as reference data for a variety of current or saved measurement data provided by a measurement data source. The reference data is preferably pre-stored and pre-generated data, i.e. data that has been recorded or generated in advance.

The term measurement data shall be understood, preferably, as time series data output by a sensor monitoring the condition of technical equipment, such as a rotational machine, e.g. an electric motor. Said sensor data can be any type of data including temperature, pressure, hight, currents, vibrations etc. which is collected, e.g., in order to determine if a device or machine functions within normal parameters. The measurement data is collected and provided by a measurement data source which may be said sensor. Very preferably the measurement data source is an electrical current sensor which monitors the input or output of electrical currents of an electrical machine but the claimed subject-matter is not limited to the compression of this kind of data type.

The difference detection unit is an element of the apparatus for compressing time series data which is configured to determine a difference between the reference data and the measurement data; preferably, by subtraction, thereby generating difference data. Further, it may output said difference data to another entity of the claimed apparatus, e.g., the data compression unit.

The term difference data shall be understood, preferably, as a data set generated by subtracting reference data from measurement data or vice versa in order to determine the absolute value of a difference between the values of the reference data and the measurement data for a given value on the time axis of the time series data. In a case in which the reference data does have a lower time resolution than the measurement data, the difference data is generated by known-in-the-art upsampling of the reference data and then performing the subtraction of reference data and measurement data with the same sampling rate/time resolution. It is noted that the generation of the difference data is based on a mathematical operation which only requires low computational effort.

An advantage offered by said generation of difference data lies in a substantial reduction of the amplitude of the difference data in comparison to the original measurement data. This reduction in amplitude requires a reduced number of bits in comparison to the original measurement data and therefore, a reduction in data size can be achieved before the difference data is compressed. Moreover, the reduction in amplitude of the measurement data to be compressed holds the advantage that the data points of the time series data output by a sensor which normally features a wide range of values are more densely accumulated around the zero point thereby increasing the chance of obtaining similar numerical values.

The data compression unit is configured to compress the difference data, e.g., output by the difference detection unit by performing, preferably, lossless data compression. As will be further described below, this may preferably be performed according to the principles of run length encoding and/or dictionary encoding, or the like.

The data export unit is configured to export/sent/transmit the compressed difference data to the data storage device, preferably a second data storage unit thereof, according to known protocols for data transfer and to further conduct data conversion of the data to be exported if necessary.

The second data storage unit preferably is a data storage unit which is similar or identical to the first data storage unit and may most preferably be configured to be connected to an external device such as a personal computer in order to allow access to the compressed difference data to be analysed. Furthermore, preferably the first and second data storage device are virtual storage devices or partitions included in the same physical storage, like the data storage device explained above.

In an alternative, the first and the second data storage units may also be the same data storage units, partitions or volumes or the like, i.e. in this case the apparatus would only include or be linked to a single data storage unit/device configured to store the reference data and the compressed difference data.

Additionally or alternatively, the data storage device, preferably including the first and/or the second (or the single) data storage unit, may also be located outside of the apparatus and, in this case, the reference data is received from an external unit (e.g., an external first data storage unit) and the compressed difference data is sent to an external unit (e.g., an external second data storage unit) by means of wireless or wired data communication. In other words, the data storage unit(s)/device(s) may be (partly) included in the claimed apparatus or they may be (partly) remotely arranged unit(s) to which the apparatus is communicably connected.

Accordingly, the above-described apparatus especially provides improved compression of time series data output by a sensor or the like. In particular the generation of difference data offers the advantage of a reduction of the amplitude of the measurement data to be compressed. This means that no iteration of the pre-processing of data is required after the generation of difference data. Therefore, a significant reduction in bit size can be achieved by the reduction in amplitude of the measurement data even before the generated difference data is compressed. In other words, the one-time pre-processing of measurement data according to the claimed subject-matter yields numerical values which are especially favourable for lossless compression methods such as run length coding or dictionary coding.

Moreover, the claimed apparatus offers the technical effect of reduced computational burden of a processor carrying out the above-described processes of the respective units. This is in particular achieved by providing an apparatus for compressing time series data that only requires one step of pre-processing of raw sensor data which is moreover only a mathematical operation of subtraction. At the same time, said pre-processing leads to a synergistic effect in terms of generating data which exhibits values which are particularly favourable for lossless compression.

Also, the claimed apparatus is well suited to tackle the challenges posed by data size and data access speed. In terms of data size, measurement data may be deleted after a certain period and/or data may be only stored when abnormal behaviour is recorded and/or data is manually secured. If the file size is reduced to half the original size, e.g., respective more of the time length of the time series data can be stored or less data storage space needs to be provided. With regard to data transmission, if the file size is half, e.g., the transmission speed of the same amount of data can be increased accordingly.

Further, the data compression unit may be configured to perform lossless compression of the difference data.

This offers the advantage of restoring the raw measurement data output by the measurement data source to its original state without loss of information. As time series data with a wide range of values is difficult to compress, sensor data can hence be restored to its original state in order to find deviations from normal operational parameters in the effort to avoid failure or to reconstruct a reason for failure of a device or machine.

Further the data compression unit may be configured to compress the difference data by run length encoding. Run length encoding (RLE) is a form of lossless data compression in which runs of data (sequences in which the same data value occurs in many consecutive data elements) are stored as a single data value and count, rather than as the original run. The basic idea of the algorithm is to replace each sequence of identical symbols by their number and, if necessary, the symbol. I.e., only the places where the symbol changes in the message are marked. Since the length information grows only logarithmically in comparison with the length of the sequence, one saves storage space considerably, particularly with long repetition sequences. Conversely, the shorter the repetitions, the smaller the saving.

For example, instead of a sequence with five repetitions of the character 0 and three times 1 such as 0000 0111 only 5 3 is stored. The start symbol must therefore be known or additionally encoded. Correspondingly, the longer a single sequence becomes, the greater the saving, because for 10 repetitions one needs two decimal places, for 100 repetitions one needs three decimal places, for 1000 repetitions, four decimal places are needed, and so on.

Run length encoding is an efficient variant of lossless compression that offers the advantages of little computational effort and good compression results especially with regard to data featuring long sections of similar or identical values such as time series data generated by monitoring an operating machine or device. Moreover, it is suitable as a precompression step in compression methods combining a set of compression techniques.

Further the data compression unit may be configured to compress the difference data by dictionary coding. Dictionary coding (DC), also known as string substitution, refers to all data compression methods that search the raw data for recurring character strings in order to store them in a so-called dictionary assigned to a substitute symbol and replace them with the symbol (e.g., the position in the dictionary).

For example, if the data to be compressed by using a dictionaried key to replace frequent numbers is an array of 1.2345, 1.2346, 1.2347 and 1.2348, the common part of the data which is 1.234 can be replaced with a key "a" and the array can be expressed as a5, a6, a7 and a8 which is shorter than the original array.

Dictionary coding is an efficient variant of lossless compression that offers the advantages of little computational effort and is especially suitable for compressing data featuring long sections of similar or identical values such as time series data generated by monitoring an operating machine or device.

It is also possible that the data compression unit compresses the difference data using a combination of RLE and DC depending on the value range and the structure of the difference data. The decision as to which method is used, if the apparatus is enabled to perform both, may be taken by a user, it may be automated, e.g. by using a machine-learning algorithm to select the appropriate method, and/or it may be pre-set as to which method is to be used for which kind of data (e.g. as a further information stored with a set of reference data).

Further, the reference data may comprise time series data points and/or an equation representing time series data points. In other words, the reference data may be a temporal succession of data points (over time) representing the values measured by sensor monitoring a machine or device. The reference data may have the form of a table or the like and may stem from previous experiments, scientific sources or previously conducted measurements under controlled conditions. The sampling frequency/resolution of those data points can be reduced in order to save storage space. However, a reduced sampling frequency/resolution can be compensated by interpolation or the like for the generation of the difference data.

The herein disclosed apparatus may receive different types of reference data depending on the type of the measurement data to be compressed. E.g., if measurement data of a machine being an electric motor of a certain type and/or with certain parameters shall be compressed, the reference data set would be input to the apparatus which stems from the same electric motor or from a comparable motor.

Time series data is a useful means for monitoring a device/machine in order to keep track of operational status and to determine normal or abnormal operation. If a machine is for example an electric machine the data regarding voltage/current input can be represented by a sine equation or a comparable mathematical representation of the data. The corresponding equation can be used as reference data in order to replace a multitude of data points with a suitable mathematical equation. This offers the advantage of simplified and reduced amount of reference data, safe storage space or reduce data traffic

Further the difference detection unit may be configured to select the reference data from a plurality of data sets to be used for creating the difference data based on the characteristics of each individual data set. In other words, the data storage device, preferably the (first) data storage unit, may hold a library/plurality of reference data (sets) with a plurality of different characteristics. Here the term characteristics is to be understood as the shape of the graph representing the time series data of a previously recorded data set. The reason for choosing the reference data to be used according to its characteristics is that the amplitude of the difference data can be reduced even further by choosing reference data that matches the measurement data well. This way the absolute values of the data points of the difference data can be further reduced.

The selection of the data sets according to their characteristics may be performed on the basis of a manual setting conducted by an operator or an automatic selection. Accordingly, an operator may choose the reference to be used for generating the difference data by selecting reference data that seems to have a shape most similar to the measurement data. On the other hand, an automatic selection of reference data to be used for generating the difference data may be performed on choosing reference data with the best fit regarding the equations representing the time series data graphs.

In other words, the better the reference data approximates the measurement data the smaller is the difference between the reference data and the measurement data. Correspondingly, the difference data has a smaller amplitude and therefore less bits need to be used for storing the reference data. This adds to the previously described advantage that difference data with a smaller amplitude result in a smaller data size of the data to be compressed and furthermore creates a difference data set which is favourable for the above-described principles of lossless compression.

Further, as noted above, the selection may be performed, alternative or additional to the above, by way of using reference data for the same type or at least the similar type of a machine for which measurement data are to be compressed, as explained further above. This may also contribute to the difference data exhibiting an good compressibility.

Further the difference detection unit may be configured to select a set of reference data according to the characteristics of a machine's operational status.

In other words, the selection of reference data from the library of reference data with a plurality of different characteristics to be used in generating difference data may be based on an operation phase of the monitored machine or device. The term operation phase is to be understood as phase in the operation of the monitored machine or device that is characteristic for an operational profile. For example, the start-up of an electric machine has another current characteristic than the continuous operation at a fixed revolution speed. As such operational phases have a distinctive signal shape of the measurement data, this fact can be utilized in choosing a suitable set of reference data for the generation of difference data in advance. The selection may be automated by way of a trained machine learning algorithm which has been trained by respective time series data to learn to compare and find the most similar ones for the selection. Also, the selection may be automated by way of additional information tagged to the reference data, e.g. in a header thereof or so, which provide the necessary selection information to the difference detection unit for selecting the most suitable reference data set for actual measurement data. This helps in finding a better fitting equation of reference data when the selection of the reference data is accordance with the actual operational state the machine or device.

In the previous example of an electrical machine a start-up phase may have different characteristics compared to an operation with constant rotation or acceleration/deceleration of the machine. Choosing the right reference data with respect to the operational status helps to achieve difference data with smaller amplitudes and therefore a size reduction prior to the compression of the difference data can already be achieved.

Further, the apparatus for compressing time series data may comprise a data size comparison unit configured to compare the size of the compressed difference data with the size of the measurement data, wherein the data export unit is further configured to export the measurement data to the data storage device, preferably the second data storage unit, if the size of the compressed difference data exceeds the size of the measurement data or to export the compressed difference data to the data storage device, preferably the second data storage unit, if the size of the measurement data exceeds the size of the compressed difference data.

This offers the advantage that in a case in which the compressed difference data may not be suitable to reduce the size of the measurement data, the original measurement data can be saved and therefore directly used in further analysis. This ensures that in a case in which generating difference data and compressing it may not result in a reduction of data size, the original measurement data is stored. This way no additional data storage becomes necessary. This also reduces the processing burden of the apparatus for compressing time series data because the difference data has not to be decompressed in order to restore the measurement data from the decompressed difference data.

Further, the apparatus for compressing time series data may further comprise a frequency analysis unit configured to perform a frequency analysis of the measurement data, extract fundamental components and convert the extracted fundamental components to wave equations, wherein the data storage device, preferably the first data storage unit thereof, is configured to store the wave equations as (additional) reference data.

This helps to further reduce the size of the difference data since the shape of the reference data can be optimized to fit the measurement data in the current state of operation of the machine. In other words, reference data is generated by using current measurement data output by the measurement data source. Therefore, the size of the difference data to be compressed can be further reduced by the improved fitting of the wave functions of the reference data and the measurement data. Also, because of using only the fundamental components noise can be removed from the reference data and the file size of the reference data can be reduced.

Further, the frequency analysis performed by the frequency analysis unit may be performed according to the principles of Fast Fourier Transform.

Fast Fourier Transform (FFT) is a commonly used tool and can be used without introducing significantly increased processing burden. Moreover, FFT is well suited to extract fundamental components from time series data that can be described by a sine wave or sine function. Moreover, by performing a frequency analysis based on FFT noise components can be removed from the reference data and a better fit of the reference data with the measurement data can be achieved.

Further, the data export unit may be configured to perform downsampling of a predetermined time range of compressed difference data and provide the downsampled compressed difference data to the data storage device, preferably the second data storage unit thereof.

This is especially beneficial for speeding up the process of accessing partial files which are of particular interest. Correspondingly, the extraction of a certain time range of the data can be easily achieved as there is no need to reconstruct all of the data. For the case of downsampled compressed difference data, downsampled compressed data and downsampled reference data can be combined to obtain the decompressed data. Also, if analysing the data in order to conduct a frequency analysis of the compressed data, there is no need to decompress the data to get the frequency spectrum by separately adding the spectrum of compressed data and reference data.

Further, there is claimed a system including the apparatus according to at least one of above configurations, a machine, preferably a rotational machine such as an electric motor, and at least one measurement data source, which is preferably a sensor device/unit, wherein the measurement data source is configured to read measurement data of the machine. The measurement data, as explained above, preferably include, e.g., electrical current measured over time, electrical voltage measured over time, mechanical vibrations measured over time, and/or other comparable characteristic electrical or mechanical parameters measured over time.

Further, there is claimed a method for compressing time series data comprising the steps: reading reference data, e.g., from a data storage device, preferably a first data storage unit thereof; reading measurement data of a machine/device recorded by a measurement data source; determining the difference values between the reference data and the measurement data, thereby generating difference data; performing compression of the obtained difference data; and exporting the compressed difference data, preferably if the size of the compressed difference data exceeds the size of the measurement data, to the data storage device, preferably the a second data storage unit thereof.

Further, the method for compressing time series data may further comprise the steps: performing a frequency analysis of the measurement data; extracting fundamental components from the measurement data; converting the extracted fundamental components to wave equations; and storing the wave equations in the data storage device, e.g. the first data storage unit, as reference data.

Moreover, the method of compressing time series data may comprise that the frequency analysis of the measurement data is performed according to the principles of Fast Fourier Transform and/or that the compression of the obtained difference value is performed by run length encoding or dictionary coding.

It is noted that in general the method may include all aspects as method steps which have been described in more detail in regard of the apparatus disclosed herein. In other words, each configuration of the apparatus described above shall also be encompassed by way of a method, which may be claimed by itself and/or by way of a computer program product claim.

Also, there is claimed a computer program product storable in a memory which, when carried out by a computer, causes the computer to perform the above-described method(s).

Summarizing, a solution is provided which offers technical benefits especially with regard to compression of time series data that is output by a sensor (as an example of a "measurement data source") monitoring the operation of a machine or device. In particular the generation of difference data is especially beneficial in achieving the goal of reducing the size of the acquired measurement data because it only requires one step of computationally undemanding pre-processing and furthermore yields data that has favourable properties for a subsequent step of lossless data compression.

In the following the claimed subject matter will be further explained based on at least one preferential example with reference to the attached drawings, wherein:
- Figure 1: shows a schematic overview of an apparatus for compressing time series data as disclosed herein;
- Figure 2: shows a schematic overview of another apparatus for compressing time series data as disclosed herein;
- Figure 3: shows a flowchart of the process of data compression as used by an apparatus as disclosed herein;
- Figure 4: shows a flowchart of another process of data compression as used by an apparatus as disclosed herein;
- Figure 5: shows a flowchart of the process of data size comparison;
- Figure 6: an exemplary diagram explaining the generation of difference data;
- Figure 7: shows an example of the data size before the compression and after the compression;
- Figure 8: shows an example of the process of dictionary coding.

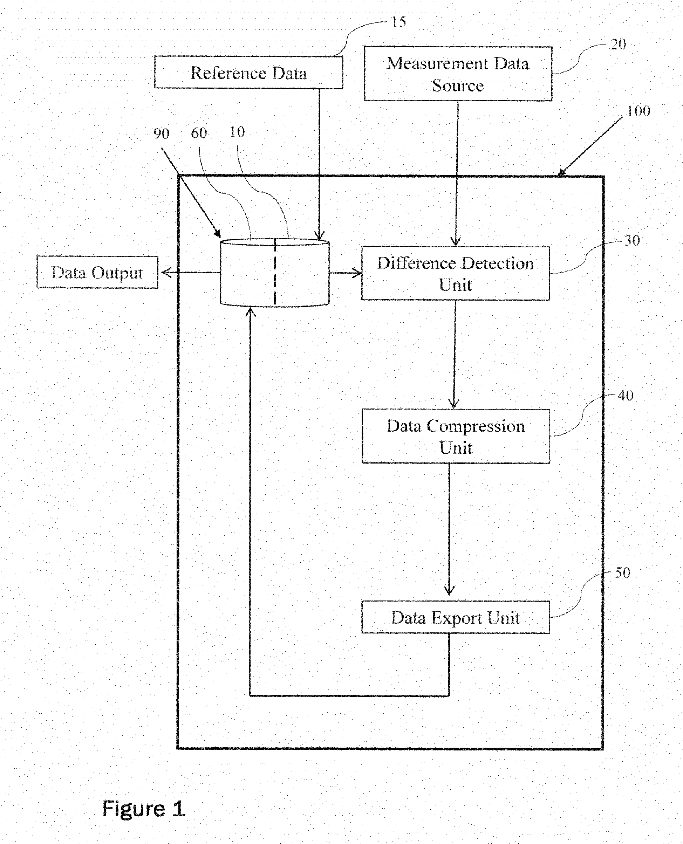

Figure 1 shows a schematic overview of the claimed apparatus 100 for recording time series data as disclosed herewith. The apparatus 100 comprises a measurement data source 20 which may be a sensor or the apparatus 100 may have a data connection to a sensor device which picks up readings from a machine or device to be monitored. In Figure 1 the measurement data source 20 is an external entity to the apparatus 100 which is a preferred option.

Also, the apparatus comprises a data storage device 90 in which the first data storage unit 10 and the second data storage unit 60 may be implemented. However, there may also be only a single data storage unit. Further, the first and the second data storage units may also be provided in the form of a virtual data storage or a partition or the like. However, the first data storage unit 10 and the second data storage unit 60 may also be implemented as to different data storage devices in order to provide a first data storage unit 10 and a second data storage unit 60. The data storage device 90 or one or both of the first and second data storage units may also be provided external to the apparatus 100 (not shown). In the following, without delimiting the disclosure thereto, the above example of a configuration of a data storage device 90 having two internal data storage units 10 and 60 included will be used for the further explanations.

Both, the first data storage unit 10 and the measurement data source 20 are configured to input data into a difference detection unit 30. More specifically, the first data storage unit 10 is configured to input reference data into the difference detection unit 30 and the measurement data source 20 is configured to input measurement data into the difference detection unit 30.

The difference detection unit 30 is configured to compared the data input from the first data storage unit 10 with the data input from the measurement data source 20. in other words, the difference detection unit 30 receives measurement data in the form of time series data and reference data in the form of time series data and creates difference data by subtracting one of the respective time series data sets from the other. It is noted, that it is not important if the measurement data is subtracted from the reference data or vice versa as long as an absolute value is obtained for each data point for which a subtraction operation is conducted. The resulting time series data that is a result of the above-described mathematical operation is then determined to be the difference data which is then temporarily stored by the difference detection unit 30. For example, if the time series measurement data include a plurality/number of measurement values, such as electrical current, each of the measurement values has been taken at a specific time t, t1, t2, etc., and the differences/difference values are then generated by subtracting a measurement value taken at time t from a reference data value taken at time t, by subtracting a measurement value take at time t1 from a reference data value taken at time t1, and the like. In this regard it is note that the time may also be construed as a measurement point number so that a first measurement data value would be compared to a first reference data value, and the like. Further, if the measurement data and/or the reference data should not be comprised of discrete values, such as discrete values in a table, but if they should be provided in the form of a continuous graph or the like, the difference detection unit may pick values for the comparison, such as by applying pre-stored time intervals or the like, e.g., the values of every millisecond, second or the like are compared to each other so that t might have the value 0s, t1 might have the value 100ms, t2 might have the value 200ms and the like.

Further, optionally, if the reference data sampling rate should be different to the measurement data sampling rate, upsampling of one of the data sets can be performed by the difference detection unit 30.

Furthermore, the difference detection unit 30 outputs the difference data to a data compression unit 40 that is configured to perform lossless compression of the difference data. This data compression may be performed according to the principles of run length encoding or dictionary coding. The type of compression is dependent on the form of the difference data. For example, run length encoding is effective when difference data with a high bit length N only contains data which fits within the bit length M. in this case, difference data with the bit length N can be converted to difference data with the bit length M. This results in a reduction of the size of the difference data. On the other hand, dictionary coding is used if the difference data consists of data featuring a set of frequently recurring numbers. For example, if the difference data is an array of 1.2345, 1.2346, 1.2347, 1.2348 and so forth, the common part of the array which is 1.234 can be replaced with a key "a" and the array can be converted to a5, a6, a7, a8 and so forth. Correspondingly, the converted array is shorted than the original array and the difference data is reduced in size. The compressed difference data is temporarily saved by the data compression unit 40.

Further, the apparatus for compressing time series data 100 comprises a data export unit 50 which receives the compressed difference data from the data compression unit 40 and compiles the received data in a data file. The data export unit 50 then sends the compiled data to the second data storage unit 60 where the data is saved. The second data storage unit 60 is configured to output the compressed and compiled data to a computer or such. The computer (not shown) may display the data to a user or may use the data for a further processing of the data, e.g., a failure analysis of the machine from which the data originate or the like.

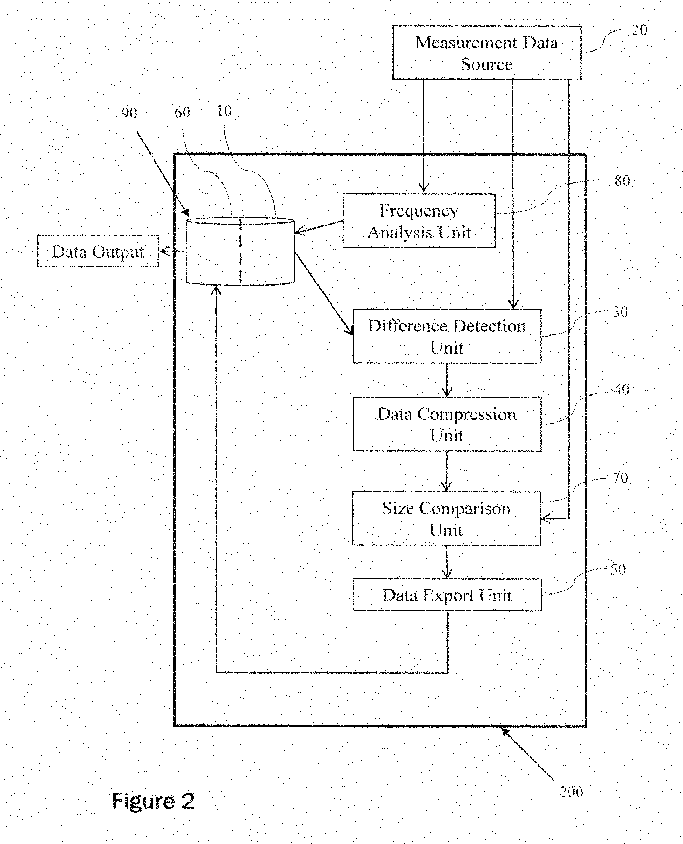

Figure 2 shows the apparatus for compressing time series data 100 according to another aspect. Features that are denoted by the same reference numerals as in Figure 1 represent the same elements as described above and their description shall be omitted. The apparatus for compressing time series data 200 shown in Figure 2 further comprises a frequency analysis unit 80 and a size comparison unit 70.

The frequency analysis unit 80 receives the measurement data from the measurement data source 20, performs a frequency analysis of the measurement data and extracts the fundamental wave components from the measurement data 20, e.g. by Fast Fourier Transform. The frequency analysis unit 80 further converts the extracted fundamental components to wave equations representing the fundamental components by a mathematical formula. Preferably said wave equations are sine wave functions or cosine wave functions. The frequency analysis unit 80 temporarily stores said wave equations and outputs them to the first data storage unit 10. The first data storage unit 10 stores the received wave equations as reference data which is time series data based on current measurement data.

The first storage unit 10 outputs the stored wave equations to the difference detection unit where it is compared with measurement data in order to generate difference data as described above. It is noted that the taking of reference data via the frequency analysis unit 80 and the difference data generation by the difference detection unit 40 may be taken at different times, most preferably, the reference data may be prestored and can be used at a later time when they need to be compared to actually measured measurement data.

Further, the difference detection unit 30 may preferably undo/reconvert the frequency analysis in order to compare the actual measurement data with the reference data, or (not shown) the frequency analysis may be applied to the actual measurement data by e.g. the difference detection unit 30 in order to compare them with the not reconverted reference data.

The difference data is then compressed by the data compression unit 40 according to the above-described principles for lossless compression. The compressed difference data is temporarily stored in the data compression unit and output to the size comparison unit 70.

The size comparison unit 70 receives measurement data from the measurement data source and the compressed difference data output by the data compression unit 40 and compares the size of the compressed difference data with the size of the measurement data. The size comparison unit 70 then determines if the size of the compressed difference data exceeds the size of the measurement data or if the size of the measurement data exceeds the size of the compressed difference data. Furthermore, the size comparison unit temporarily stores whichever data set is smaller and outputs either the compressed difference data or the measurement data to the data export unit 50. As already described, the data export unit 50 exports the data received from the size comparison unit 70 to the second storage unit 60 after compiling it.

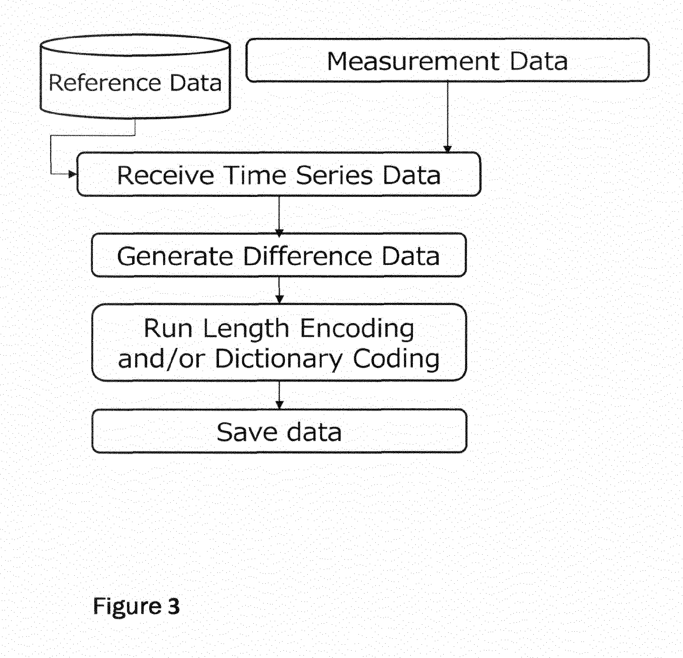

Figure 3 is a flowchart of the process of data compression performed by the apparatus for compressing time series data 100 shown in Figure 1. The difference detection unit 30 receives the reference data stored in the first storage device and the measurement data output by the measurement data source 20 and generates the difference data as previously described. Then the data compression unit 40 compresses the difference data by performing run length encoding and/or bit length encoding. After data compilation performed by the data export unit 50 the compressed difference data is then saved in the second data storage unit 60 or in another unit.

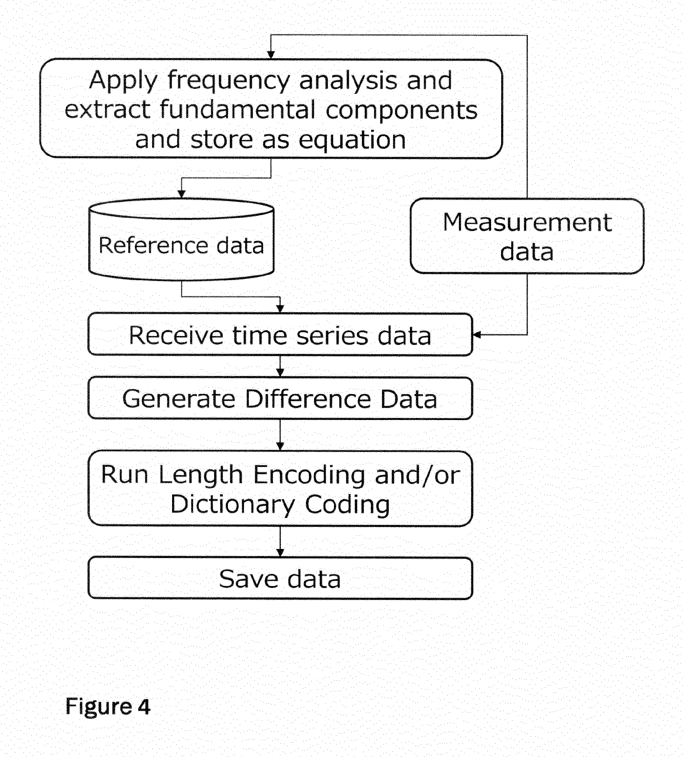

Figure 4 is a flowchart of the process of data compression performed by the apparatus for compressing time series data 200 shown in Figure 2. The frequency analysis unit 80 receives measurement data from the measurement data source 20 and performs a frequency analysis on the measurement data. Also, the frequency analysis unit 80 extracts the fundamental components of the measurement data obtained by frequency analysis (e.g. FFT) and outputs them to the first data storage unit 10 to be stored as reference data. The reference data is then output to the difference detection unit 30. At the same time measurement data output from the measurement data source 20 is also received by the difference detection unit 30. The difference detection unit 30 then generates the difference data as previously described. Then the data compression unit 40 compresses the difference data by performing run length encoding or bit length encoding. After data compilation performed by the data export unit 50 the compressed difference data is then saved in the second data storage unit 60 or in another unit.

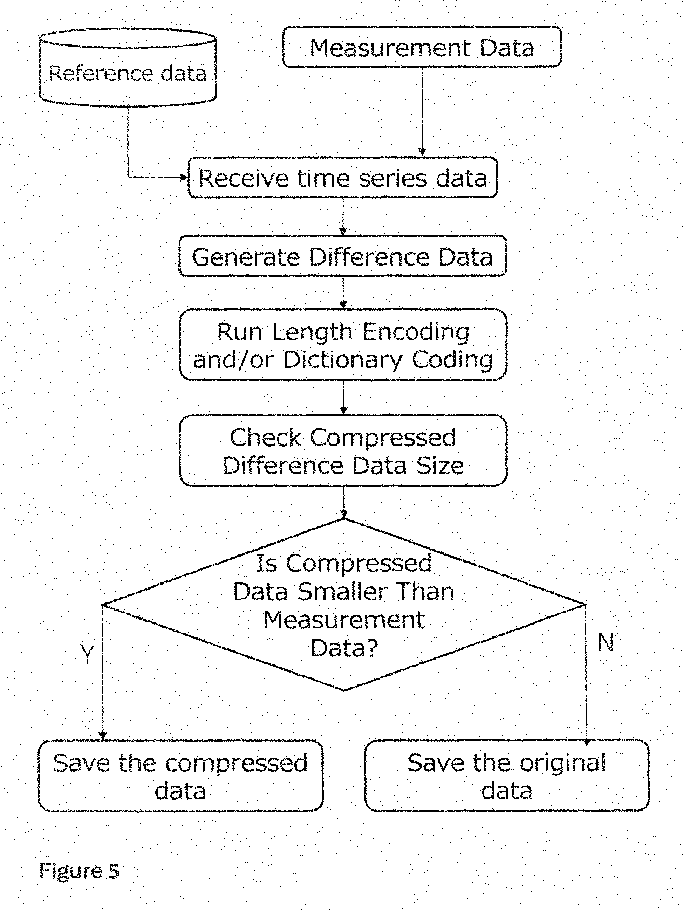

Figure 5 is a flowchart of the process of data size comparison. It is noted that although Figure 5 shows the process of data compression performed by the apparatus for compressing time series data 100 shown in Figure 1 the process of data size comparison may be also be performed by the apparatuses for compressing time series data 200 shown in Figure 2. in particular, after the difference data was compressed by the data compression unit 40, the size comparison unit 70 checks if the size of the compressed difference data for its size and determines in a successive step, if the compressed difference data is smaller in size than the original measurement data. When the size of the compressed difference data is smaller than the size of the original measurement data, the size comparison unit 70 saves the compressed difference data and outputs it to the data export unit 50. On the other hand, when the size of the compressed difference data is larger than the size of the original measurement data, the size comparison unit 70 saves the original measurement data and outputs it to the data export unit 50.

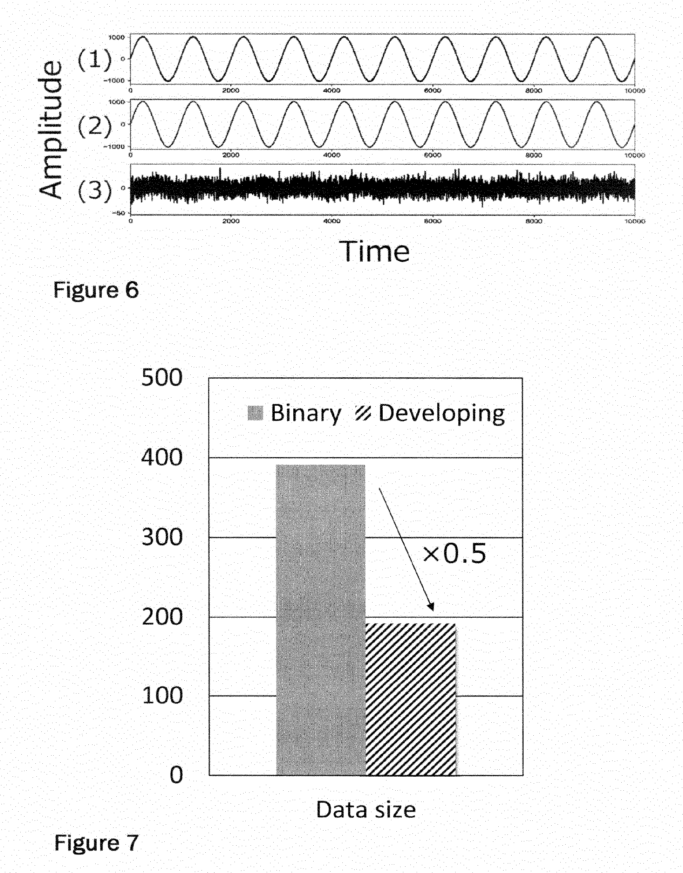

Figure 6 is an exemplary diagram explaining the generation of difference data. It shows the measurement data marked by "(1)" output from the measurement data source 20, the reference data marked by "(2)" and the generated difference data marked by "(3)". As most of e.g. electrical current data contains sinusoidal components as a main frequency component as well as smaller amplitudes of different frequency components the measurement data "(1)" may look like the wave function shown in Figure 6 after the main frequency components have been extracted and converted by the frequency analysis unit 80 in order to generate the reference data (2). In other words, the reference data (2) can be expressed by a sinusoidal equation yielding amplitude, frequency and phase. The generated difference data, which has been obtained by subtracting the measurement data from the reference data or vice versa has a smaller maximum amplitude (in Fig. 6, e.g., the range reduces from -1000..1000 to -50..50) and hence can be stored while necessitating smaller bit numbers. Moreover, as the values of the difference data are more densely accumulated around the origin of the shown graphs, the chance of obtaining data with similar values is increased. For example, as previously described, the data may be 1.234, 1.235, 1.236 and so forth. In this case, the data can be effectively compressed using dictionary coding. For instance, 1.23 can be replaced with a string "a" and correspondingly 1.234 and 1.235 can be expressed as a4 and a5.

Figure 7 shows an example of the data size before the compression and after the compression performed by the data compression unit 40. Initially the waveform of the measurement data had a size of 391kB and after the compression the size was reduced to 192kB by performing the above-described steps. It is noted, that there is a possibility that the data size of the compressed difference data is larger than or equal to the size of the original measurement data. According to the steps described in Figure 5, if the size of the compressed difference data is larger than the original measurement data, the original measurement data is exported by the data export unit 50. This way, compressed data is only exported if it actually helps in reducing the size of the data to be output by the apparatus for compressing time series data.

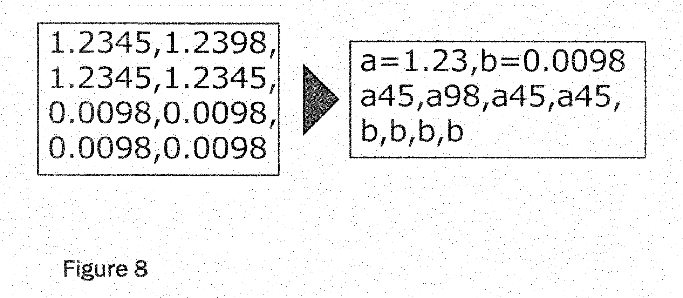

Figure 8 is an example of the process of dictionary coding which may be performed by the data compression unit 40. Recurring values of difference data are replaced with a key. In this example, the values 1.23 and 0.0098 are replaced with the keys "a" and "b" respectively. Accordingly, the set of values depicted on the left side of Figure 8 can be reduced to the values shown on the right side. This method is effective in the compression of data sets with similar values and compressing and decompressing of the data can be performed with little computational effort.

Summarizing, a solution is provided which offers technical benefits especially with regard to compression of time series data that is output by a sensor (as an example of a "measurement data source") monitoring the operation of a machine or device. In particular the generation of difference data is especially beneficial in achieving the goal of reducing the size of the acquired measurement data because it only requires one step of computationally undemanding pre-processing and furthermore yields data that has favourable properties for a subsequent step of lossless data compression.

As will be appreciated by one of skill in the art, the present disclosure, as described hereinabove and the accompanying figures, may be embodied as a method, an apparatus (including a device, machine, system, computer program product, and/or any other apparatus), or a combination of the foregoing.

Accordingly, embodiments/aspects of the present disclosure may take the form of an entirely hardware embodiment, an entirely software embodiment (including firmware, resident software, micro-code, etc.), or an embodiment combining software and hardware aspects that may generally be referred to herein as a "system". Furthermore, embodiments of the present disclosure may take the form of a computer program product on a computer-readable medium having computer-executable program code embodied in the medium.

It should be noted that arrows may be used in drawings to represent communication, transfer, or other activity involving two or more entities. Double-ended arrows generally indicate that activity may occur in both directions (e.g., a command/request in one direction with a corresponding reply back in the other direction, or peer-to-peer communications initiated by either entity), although in some situations, activity may not necessarily occur in both directions.

Single-ended arrows generally may indicate activity exclusively or predominantly in one direction, although it should be noted that, in certain situations, such directional activity actually may involve activities in both directions (e.g., a message from a sender to a receiver and an acknowledgement back from the receiver to the sender, or establishment of a connection prior to a transfer and termination of the connection following the transfer). Thus, the type of arrow used in a particular drawing to represent a particular activity is exemplary and should not be seen as limiting.

Aspects are described hereinabove with reference to flowchart illustrations and/or block diagrams of methods and apparatuses, and with reference to a number of sample views of a graphical user interface generated by the methods and/or apparatuses. It will be understood that each block of the flowchart illustrations and/or block diagrams, and/or combinations of blocks in the flowchart illustrations and/or block diagrams, as well as the graphical user interface, can be implemented by computer-executable program code.

The computer-executable program code may be provided to a processor of a general purpose computer, special purpose computer, or other programmable data processing apparatus to produce a particular machine, such that the program code, which executes via the processor of the computer or other programmable data processing apparatus, create means for implementing the functions/acts/outputs specified in the flowchart, block diagram block or blocks, figures, and/or written description.

These computer-executable program code may also be stored in a computer-readable memory that can direct a computer or other programmable data processing apparatus to function in a particular manner, such that the program code stored in the computer readable memory produce an article of manufacture including instruction means which implement the function/act/output specified in the flowchart, block diagram block(s), figures, and/or written description.

The computer-executable program code may also be loaded onto a computer or other programmable data processing apparatus to cause a series of operational steps to be performed on the computer or other programmable apparatus to produce a computer-implemented process such that the program code which executes on the computer or other programmable apparatus provides steps for implementing the functions/acts/outputs specified in the flowchart, block diagram block(s), figures, and/or written description.

Alternatively, computer program implemented steps or acts may be combined with operator or human implemented steps or acts in order to carry out an embodiment.

Communication networks generally may include public and/or private networks; may include local-area, wide-area, metropolitan-area, storage, and/or other types of networks; and may employ communication technologies including, but in no way limited to, analogue technologies, digital technologies, optical technologies, wireless technologies (e.g., Bluetooth), networking technologies, and internetworking technologies.

It should also be noted that devices may use communication protocols and messages (e.g., messages created, transmitted, received, stored, and/or processed by the device), and such messages may be conveyed by a communication network or medium.

Unless the context otherwise requires, the present disclosure should not be construed as being limited to any particular communication message type, communication message format, or communication protocol. Thus, a communication message generally may include, without limitation, a frame, packet, datagram, user datagram, cell, or other type of communication message.

Unless the context requires otherwise, references to specific communication protocols are exemplary, and it should be understood that alternative embodiments may, as appropriate, employ variations of such communication protocols (e.g., modifications or extensions of the protocol that may be made from time-to-time) or other protocols either known or developed in the future.

It should also be noted that logic flows may be described herein to demonstrate various aspects and should not be construed to limit the disclosure to any particular logic flow or logic implementation. The described logic may be partitioned into different logic blocks (e.g., programs, modules, functions, or subroutines) without changing the overall results.

Often times, logic elements may be added, modified, omitted, performed in a different order, or implemented using different logic constructs (e.g., logic gates, looping primitives, conditional logic, and other logic constructs) without changing the overall results.

The present disclosure may be embodied in many different forms, including, but in no way limited to, computer program logic for use with a processor (e.g., a microprocessor, microcontroller, digital signal processor, or general purpose computer), programmable logic for use with a programmable logic device (e.g., a Field Programmable Gate Array (FPGA) or other PLD), discrete components, integrated circuitry (e.g., an Application Specific integrated Circuit (ASIC)), or any other means including any combination thereof Computer program logic implementing some or all of the described functionality is typically implemented as a set of computer program instructions that is converted into a computer executable form, stored as such in a computer readable medium, and executed by a microprocessor under the control of an operating system. Hardware-based logic implementing some or all of the described functionality may be implemented using one or more appropriately configured FPGAs.

Computer program logic implementing all or part of the functionality previously described herein may be embodied in various forms, including, but in no way limited to, a source code form, a computer executable form, and various intermediate forms (e.g., forms generated by an assembler, compiler, linker, or locator).

Source code may include a series of computer program instructions implemented in any of various programming languages (e.g., an object code, an assembly language, or a high-level language such as Fortran, C, C++, JAVA, or HTML) for use with various operating systems or operating environments. The source code may define and use various data structures and communication messages. The source code may be in a computer executable form (e.g., via an interpreter), or the source code maybe converted (e.g., via a translator, assembler, or compiler) into a computer executable form.

Computer-executable program code for carrying out operations of embodiments of the present disclosure may be written in an object oriented, scripted or unscripted programming language such as Java, Perl, Smalltalk, C++, or the like. However, the computer program code for carrying out operations of embodiments may also be written in conventional procedural programming languages, such as the "C" programming language or similar programming languages.

Computer program logic implementing all or part of the functionality previously described herein may be executed at different times on a single processor (e.g., concurrently) or may be executed at the same or different times on multiple processors and may run under a single operating system process/thread or under different operating system processes/threads.

Thus, the term "computer process" may refer generally to the execution of a set of computer program instructions regardless of whether different computer processes are executed on the same or different processors and regardless of whether different computer processes run under the same operating system process/thread or different operating system processes/threads.

The computer program may be fixed in any form (e.g., source code form, computer executable form, or an intermediate form) either permanently or transitorily in a tangible storage medium, such as a semiconductor memory device (e.g., a RAM, ROM, PROM, EEPROM, or Flash-Programmable RAM), a magnetic memory device (e.g., a diskette or fixed disk), an optical memory device (e.g., a CD-ROM), a PC card (e.g., PCMCIA card), or other memory device.

The computer program may be fixed in any form in a signal that is transmittable to a computer using any of various communication technologies, including, but in no way limited to, analog technologies, digital technologies, optical technologies, wireless technologies (e.g., Bluetooth), networking technologies, and internetworking technologies.

The computer program may be distributed in any form as a removable storage medium with accompanying printed or electronic documentation (e.g., shrink wrapped software), preloaded with a computer system (e.g., on system ROM or fixed disk), or distributed from a server or electronic bulletin board over the communication system (e.g., the Internet or World Wide Web).

Hardware logic (including programmable logic for use with a programmable logic device) implementing all or part of the functionality previously described herein may be designed using traditional manual methods, or may be designed, captured, simulated, or documented electronically using various tools, such as Computer Aided Design (CAD), a hardware description language (e.g., VHDL or AHDL), or a PLD programming language (e.g., PALASM, ABEL, or CUPL).

Any suitable computer readable medium may be utilized. The computer readable medium may be, for example but not limited to, an electronic, magnetic, optical, electromagnetic, infrared, or semiconductor system, apparatus, device, or medium.

More specific examples of the computer readable medium include, but are not limited to, an electrical connection having one or more wires or other tangible storage medium such as a portable computer diskette, a hard disk, a random access memory (RAM), a read-only memory (ROM), an erasable programmable read-only memory (EPROM or Flash memory), a compact disc read-only memory (CD-ROM), or other optical or magnetic storage device.

Programmable logic may be fixed either permanently or transitorily in a tangible storage medium, such as a semiconductor memory device (e.g., a RAM, ROM, PROM, EEPROM, or Flash-Programmable RAM), a magnetic memory device (e.g., a diskette or fixed disk), an optical memory device (e.g., a CD-ROM), or other memory device.

The programmable logic may be fixed in a signal that is transmittable to a computer using any of various communication technologies, including, but in no way limited to, analogue technologies, digital technologies, optical technologies, wireless technologies (e.g., Bluetooth), networking technologies, and internetworking technologies.

The programmable logic may be distributed as a removable storage medium with accompanying printed or electronic documentation (e.g., shrink wrapped software), preloaded with a computer system (e.g., on system ROM or fixed disk), or distributed from a server or electronic bulletin board over the communication system (e.g., the Internet or World Wide Web). Of course, some aspects may be implemented as a combination of both software (e.g., a computer program product) and hardware. Still other embodiments of the may be implemented as entirely hardware, or entirely software.

While certain exemplary aspects have been described and shown in the accompanying drawings, it is to be understood that such aspects are illustrative, and that the embodiments are not limited to the specific constructions and arrangements shown and described, since various other changes, combinations, omissions, modifications and substitutions, in addition to those set forth in the above paragraphs, are possible.

Those skilled in the art will appreciate that various adaptations, modifications, and/or combination of the just described embodiments can be configured. Therefore, it is to be understood that, within the scope of the appended claims, the disclosure may be practiced other than as specifically described herein. For example, unless expressly stated otherwise, the steps of processes described herein may be performed in orders different from those described herein and one or more steps may be combined, split, or performed simultaneously.

Those skilled in the art will also appreciate, in view of this disclosure, that different embodiments or aspects described herein may be combined to form other embodiments.

## Claims

1. Apparatus for compressing time series data, the apparatus (100) comprising:
a difference detection unit (30) configured to determine difference data from reference data and measurement data, the reference data and the measurement data received from a data storage device (90) and a measurement data source (20), respectively;
a data compression unit (40) configured to compress the difference data determined by the difference detection unit (30);
a data export (50) unit configured to provide the compressed difference data to the data storage device (90) configured to save the compressed difference data.

2. The apparatus for compressing time series data (100) according to claim 1,
wherein the data compression unit (40) is configured to perform lossless compression of the difference data.

3. The apparatus for compressing time series data (100) according to claim 2,
wherein the data compression unit (40) is configured to compress the difference data by run length encoding.

4. The apparatus for compressing time series data (100) according to claim 2,
wherein the data compression unit (40) is configured to compress the difference data by dictionary coding.

5. The apparatus for compressing time series data (100) according to at least one of the previous claims,
wherein the reference data comprises time series data points and/or an equation representing time series data points.

6. The apparatus for compressing time series data (100) according to at least one of the previous claims,
wherein the difference detection unit (30) is configured to select the reference data from a plurality of data sets to be used for creating the difference data based on the characteristics of each individual data set.

7. The apparatus for compressing time series data (100) according to claim 6,
wherein the difference detection unit (30) is configured to select a set of reference data according to the characteristics of a machine operational status.

8. The apparatus for compressing time series data (100) according to at least one of the previous claims, further comprising:
a data size comparison unit (70) configured to compare the size of the compressed difference data with the size of the measurement data,
wherein the data export unit (50) is configured to send the measurement data to the data storage device (90) if the size of the compressed difference data exceeds the size of the measurement data or to provide the compressed difference data to the data storage device (90) if the size of the measurement data exceeds the size of the compressed difference data.

9. The apparatus for compressing time series data (100) according to at least one of the previous claims, further comprising:
a frequency analysis unit (80) configured to perform a frequency analysis of the measurement data, extract fundamental components and convert the extracted fundamental components to wave equations,
wherein a first data storage unit (10) of the data storage device (90) is configured to store the wave equations as reference data.

10. The apparatus for compressing time series data (100) according to claim 9,
wherein the frequency analysis is performed by performing Fast Fourier Transform.

11. The apparatus for compressing time series data (100) according to at least one of the previous claims,
wherein the data export unit (50) is configured to perform downsampling of a predetermined time range of compressed difference data and provide the downsampled compressed difference data to a second data storage unit (60) of the data storage device (90).

12. A system including the apparatus according to at least one of claims 1 to 11, a rotational machine and at least one measurement data source (20) configured to read measurement data of the rotational machine.

13. Method for compressing time series data comprising the steps:
reading reference data;
reading measurement data of a machine/device recorded by a measurement data source;
determining difference data from the reference data and the measurement data;
performing compression of the obtained difference data;
determining the size of the compressed difference data;
providing the compressed difference data to a data storage device.

14. The method for compressing time series data according to claim 13 further comprising the steps:
performing a frequency analysis of the measurement data;
extracting fundamental components from the measurement data;
converting the extracted fundamental components to wave equations; and
storing the wave equations in a first data storage unit (10) as reference data.

15. The method for compressing time series data according to claims 13 or 14,
wherein performing the frequency analysis of the measurement data is performed according to the principles of Fast Fourier Transform.

16. The method for compressing time series data according to at least one of claims 13 to 15,
wherein compression of the obtained difference data is performed by run length encoding or dictionary coding.

17. Computer Program Product storable in a memory which, when carried out by a computer, causes the computer to perform the method according to at least one of claims 13 to 16.
